(19) Europäisches Patentamt / European Patent Office / Office européen des brevets

(11) **EP 2 436 806 B1**

## (12) FASCICULE DE BREVET EUROPEEN

(45) Date de publication et mention
de la délivrance du brevet:
**18.02.2015 Bulletin 2015/08**

(51) Int Cl.:
***C23C 30/00*** *(2006.01)* ***F01D 25/00*** *(2006.01)*
*C30B 11/12* *(2006.01)*

(21) Numéro de dépôt: **11290441.2**

(22) Date de dépôt: **27.09.2011**

(54) **Procédé pour former un revêtement protecteur contre l'oxydation à haute température sur un matériau composite réfractaire à base de silicium et de niobium**

Verfahren zum Herstellen eine hohe Temperatur oxidation-beständige Beschichtung auf einem Silikon et Niobium-basierten Kompositmaterial

Method for making a protective coating against oxidation at high temperature for refractory materials based on silicon and niobium.

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.09.2010 FR 1003882**

(43) Date de publication de la demande:
**04.04.2012 Bulletin 2012/14**

(73) Titulaire: **ONERA (Office National d'Etudes et de Recherches Aérospatiales)
92320 Châtillon (FR)**

(72) Inventeurs:
• **Bacos, Marie-Pierre
92160 Antony (FR)**
• **Josso, Pierre
22430 Erquy (FR)**

(74) Mandataire: **Plaçais, Jean Yves et al
Cabinet Netter
36, avenue Hoche
75008 Paris (FR)**

(56) Documents cités:
**EP-A2- 1 229 146**

• **CHEN ET AL: "Deposition of Cr-modified silicide coatings on Nb-Si system intermetallics", INTERMETALLICS, ELSEVIER SCIENCE PUBLISHERS B.V, GB, vol. 15, no. 5-6, 19 avril 2007 (2007-04-19), pages 805-809, XP022035047, ISSN: 0966-9795, DOI: DOI:10.1016/J.INTERMET.2006.10.033**

**Description**

L'invention concerne un procédé pour former un revêtement protecteur contre l'oxydation à haute température sur une surface d'un matériau composite réfractaire à base de silicium et de niobium. Elle concerne aussi des pièces en matériau composite, spécialement des pièces de moteurs aéronautiques, ainsi protégées par ce procédé.

La tenue mécanique et la résistance à l'oxydation des matériaux utilisés dans les turbines des moteurs aéronautiques limitent les performances de ces dernières. Des études prospectives récentes montrent que, pour les aubes de turbine, pour lesquelles la température de paroi atteint actuellement 1050 - 1100°C, l'optimisation des compositions des alliages métalliques employés (superalliages à base de nickel) et des procédés d'élaboration, l'amélioration des circuits internes de refroidissement des pièces et l'emploi de revêtements d'isolation thermique ne permettront pas d'atteindre les températures de paroi visées, de l'ordre de 1300°C. Une voie envisagée pour fonctionner à de telles températures est le recours à des matériaux composites constitués de deux types de phases fortement réfractaires, l'une métallique Mss (où Mss désigne une phase en solution solide et M est une base Nb alliée avec de nombreux éléments tels Si, Ti, Cr, Hf, Al, etc..) conférant au matériau une ténacité suffisante à température ambiante, et l'autre intermétallique $M_5Si_3$ apportant la résistance et la tenue au fluage souhaitées à haute température. Ces matériaux sont appelés ci-après « matériaux composites de type Nb-Si ». Ce sont ces matériaux qui sont concernés par l'invention.

L'emploi de ces matériaux composites de type Nb-Si est aussi envisagé à moyenne température (700-1000°C) pour les turbines basse pression en remplacement des aubes actuellement en service, qui sont coulées en superalliages à base de nickel, et dont la densité varie de 7,75 à 8,6. Le recours à ces matériaux de type Nb-Si, dont la densité varie entre 6,6 et 7,2, permet un allègement des structures, ce qui constitue un enjeu stratégique important pour les motoristes, par exemple.

Cependant, leur développement est freiné par leur faible résistance à l'oxydation à moyenne ou haute température, et ce, malgré un grand nombre d'éléments « favorables » ajoutés à leur composition initiale (Hf, Si, Cr, B, C, Zr, Ti et Al). En effet, lorsqu'un tel matériau est soumis aux conditions de fonctionnement des turbines à gaz il est détruit par oxydation entre quelques minutes et une dizaine d'heures, selon la nuance utilisée.

Il apparaît que de façon générale au-delà de 800°C, l'oxygène pénètre dans les phases métalliques pour les oxyder en premier, en laissant dans un premier temps les phases siliciure ($M_5Si_3$) virtuellement non attaquées. Il semble que les interfaces ainsi que les joints de grains assistent la diffusion de l'oxygène. Puis les phases $M_5Si_3$ s'oxydent à leur tour.

Un autre problème réside dans le fait que, à faible température, typiquement entre 500 et 800°C, ce type de matériau est incapable de développer rapidement une couche d'oxydes protecteurs en raison d'une cinétique de diffusion très faible dans les phases métalliques Mss. Il en résulte une oxydation préférentielle des phases $M_5Si_3$ qui forment des oxydes friables et non protecteurs, ce qui entraîne une destruction de ces phases et, de proche en proche, du matériau. Ce type d'oxydation est appelé « effet peste ».

Des solutions de protection de cette famille d'alliages ont déjà été proposées. Par exemple, dans le brevet US 4 904 546 (M. R. Jackson, 27/02/1990), il est proposé une protection à base de ruthénium par dépôt physique, type projection plasma, répondant à la formule :

$$(Ru_{de\ (19-x)\ à\ (34-x)}(\Sigma Fe+Ni+Co)_x Al_{de\ 22\ à\ 28} Cr_{de\ (5.6-y)\ à\ (44-y)} Fe_y$$

avec la composition préférée : $Cr_{55}Al_{20}Ru_{14}Fe_{11}$.

Le brevet US 4 980 244 du même demandeur enseigne une variante de ce revêtement où de l'yttrium est ajouté à hauteur de 0,2 % atomique en substitution du ruthénium. Outre la difficulté d'appliquer un tel revêtement, on notera que la raréfaction des ressources fait que le choix du ruthénium n'est pas pérenne.

Dans un autre brevet, US 5 019 334, M. R. Jackson propose d'utiliser un composé MCrAlY (où M = Ni, Co et/ou Fe) en tant que revêtement protecteur de ces alliages et d'accommoder le différentiel de dilatation thermique par ajout d'alumine dans le revêtement. Optionnellement il est suggéré d'utiliser les alliages RuCrAl décrits plus haut.

Une autre solution, proposée par M. R. Jackson et al. dans US 5 932 033, consiste à augmenter la tenue intrinsèque du matériau à l'oxydation à haute température grâce à une augmentation de sa teneur en chrome. Dès lors de nouvelles phases supplémentaires, à savoir les phases de Laves, résistantes à l'oxydation, de composition $Cr_2M$ (où M = Nb + Ti + Hf), sont créées dans ce composite. Le matériau ainsi décrit peut être utilisé en tant que tel ou en tant que revêtement. Une autre version de ce matériau est enseignée dans le brevet US 6 419 765. Ces deux matériaux sont censés fonctionner sans revêtement pendant au moins 100 heures à une température comprise entre 1400 et 1600°F (745 et 856°C). Mais les phases de Laves sont bien connues pour être très fragiles.

Le brevet US 6 521 356 (Zhao et al.) enseigne qu'il est possible de protéger ce type de matériau avec un revêtement à base de niobium, de silicium, de titane et de chrome, ce revêtement étant compatible avec l'ajout d'une barrière thermique. Ce revêtement contient de nombreux éléments et est déposé par une dispersion (en anglais « slurry ») : le composant à revêtir est plongé dans une dispersion de poudres dans un liant organique visqueux. La composition préférée contient 66 % de silicium, 10 % de titane, 5 % de chrome et 19 % de niobium (% atomiques). Cette composition répond à la formule plus générale suivante : $Nb_{1-x-y}Ti_xCr_ySi_2$ où $1 > (x + y) \geq 0$. Toutefois, cette phase est fragile et peut générer des fissures à l'interface. On peut retrouver dans la composition de cette protection des éléments tels que le bore, l'étain et le fer à condition que leur concentration ne dépasse pas 5 % atomique. Enfin, il est à noter que cette protection peut être complétée par le dépôt d'une barrière thermique classique composée soit de zircone, de zircone stabilisée par l'yttrine, de zircon (silicate de zirconium, $ZrSiO_4$) et/ou de mullite.

Tous les revêtements créés par les diverses techniques de protection par dépôt physique, plasma etc. ne permettent pas de protéger le matériau composite de type Nb-Si pour les applications visées, car le revêtement a un coefficient de dilatation thermique différent de celui du matériau et toute fissuration entraîne une oxydation catastrophique du matériau composite type Nb-Si. Il faut rappeler que ce matériau est détruit après 1 cycle d'une heure sous air à 1200°C et 2 cycles d'une heure sous air à 1000°C.

Selon Guo, X.P., Zhao, L.X., Guan, P., Kusabiraki, K. 2007 Materials Science Forum 561-565 (PART 1), pp. 371-374 il est possible de protéger ce type de matériau avec un revêtement à base de silicium déposé par cémentation activée (en anglais « pack cementation ») mais avec un activateur halogéné, du type halogénure d'ammonium, qui en se décomposant forme un acide halogéné gazeux. Xiaoxia Li et Chingen Zhou, 2007 Materials Science Forum 546-549 (PART 3), pp. 1721-1724, ont appliqué la siliciuration par cémentation activée par un activateur halogéné sur un alliage de siliciure de niobium revêtu par un MCrAlY déposé par projection plasma sous air, le revêtement obtenu uniquement par siliciuration n'étant pas assez protecteur.

Chen Chen et al dans Intermetallics, 15 (2007) 805-809, proposent également de protéger un matériau de type Nb-Si avec un revêtement de silicium comprenant aussi du chrome. Le chrome est déposé par cémentation activée à partir de poudre de chrome et d'un activateur halogéné, du type halogénure d'ammonium, qui en se décomposant forme un acide halogéné gazeux. Le silicium est déposé soit par cémentation activée à partir de poudres de silicium et d'un activateur halogéné, soit par des sels fondus.

Toujours à partir de procédés de cémentation activée avec activateur halogéné, Tian et al. proposent un revêtement à base de silicium et comprenant soit de l'aluminium (Surface and Coating Technology, 203 (2009) 1161-1166) soit de l'yttrium (Surface and Coating Technology, 204 (2009) 313-318).

Mais ces techniques avec emploi d'activateurs halogénés forment, avec les composants des siliciures de niobium, des composés halogénés, volatils, ce qui dégrade localement la microstructure. Il y a donc nécessité de développer une technique qui permette de créer un revêtement par diffusion sans utiliser de gaz halogéné.

De plus, la description de toutes ces techniques de protection de matériaux de type Nb-Si montre qu'une protection efficace des alliages niobium silicium est très difficile à obtenir, tant à la température dite de « corrosion peste » qu'à haute température. Pour éviter cet « effet peste » il faut isoler le siliciure de l'atmosphère.

L'invention a notamment pour but de surmonter tous ces inconvénients.

Les travaux menés par le demandeur ont montré que la protection d'un siliciure à haute température ne peut être assurée que par un revêtement réfractaire adhérent, étanche ou freinant la diffusion de l'oxygène. Ce revêtement doit en outre présenter de bonnes propriétés viscoplastiques pour pouvoir colmater en service les fissures et être auto-cicatrisant en cas d'écaillage de l'oxyde ou de sa volatilisation.

L'invention propose à cet effet un procédé pour former un revêtement protecteur contre l'oxydation à haute température sur une surface d'un matériau composite réfractaire à base de silicium et de niobium, dans lequel on fait réagir sur du chrome présent sur la surface à protéger un gaz réactif contenant du silicium et de l'oxygène pour élaborer un revêtement composite à deux phases, dont une première phase est une phase oxyde à base de silice présentant des caractéristiques viscoplastiques et dont une seconde phase est à base de silicium, de chrome et d'oxygène, et dans lequel l'on fait coalescer lesdites première phase et seconde phase à haute température, ce qui permet de former un revêtement protecteur dans lequel la seconde phase sert de réservoir pour reformer, en service, la première phase par réaction avec un gaz oxydant.

Ainsi, pour protéger ce matériau composite de type Nb-Si, le procédé de l'invention permet de créer un revêtement composite constitué de deux phases à coefficients de dilatation différents afin d'accommoder les contraintes thermomécaniques en service.

La première phase est constituée d'une phase oxyde à base de silice, qui est protectrice et viscoplastique à la température d'utilisation. Elle peut contenir en outre des éléments fondants de type bore et/ou germanium afin d'ajuster ses propriétés viscoplastiques selon le domaine de température visé.

La seconde phase contient essentiellement du silicium, du chrome et de l'oxygène. Elle peut contenir aussi d'autres éléments, par exemple du bore et/ou de l'aluminium et/ou du fer. Cette seconde phase servira de réservoir pour reformer, en service, la première phase par réaction avec l'oxygène ou tout autre gaz oxydant, par exemple de la vapeur d'eau.

Ainsi, lorsqu'une pièce en matériau composite de type Nb-Si, munie d'un revêtement selon l'invention, sera soumise à une atmosphère gazeuse oxydante à haute température, la seconde phase permettra de reformer la première phase.

La technique actuellement privilégiée pour permettre d'obtenir l'ensemble de ces « éléments » est une technique dérivée de la technique dite « VLS » (abréviation de « Vapor Liquid Solid). Cette technique « VLS » peut être conjuguée ici avec une phase de pré-dépôt métallique si l'élément (typiquement le chrome) n'est pas en quantité suffisante dans le matériau composite de type Nb-Si

L'invention a donc pour objet le développement d'une technique adaptée à ce type de matériau composite de Nb-Si et permettant la formation d'un revêtement lui aussi composite base silice/ silicium, chrome, oxygène dopé et/ou modifié par un élément fondant tel que le bore et/ou le germanium.

L'idée de base est de faire réagir l'élément chrome soit provenant de la composition de l'alliage, soit apporté au préalable, avec des gaz contenant du silicium, de l'oxygène et éventuellement d'autres éléments tels que le bore, le germanium etc. Les techniques pour apporter le chrome peuvent être de type humide (revêtement électrolytique, sels-fondus par exemple) ou physique (pulvérisation cathodique, PVD, magnétron par exemple) ou toute autre technique de dépôt de chrome bien connue de l'homme de l'art. Les gaz fournissant le silicium, l'oxygène et tout autre élément type B, Ge etc. sont fabriqués *in situ* dans le réacteur à partir de poudres standards du commerce.

D'autres caractéristiques complémentaires de l'invention sont indiquées ci-après.

- La première phase est à base de silice ($SiO_2$) et la seconde phase à base de silicium, de chrome et d'oxygène (CrSiO) ;

- le gaz réactif contient du monoxyde de silicium (SiO) et est produit in situ, par exemple à partir d'un cément donneur contenant de la silice ($SiO_2$) soumis à une température supérieure ou égale à 1450°C (le monoxyde de silicium peut être obtenu par activation d'un mélange de poudre de silicium et de silice) ;

- le cément donneur contient par exemple un mélange de silice ($SiO_2$) et de carbure de silicium (SiC) sous forme de poudre (ce cément peut être remplacé par une poudre de SiO dont la température d'évaporation est comprise entre 1100 et 1400°C) ;

- la première phase contient en outre des éléments fondants de type bore et/ou germanium, ce qui permet d'ajuster les caractéristiques viscoplastiques de cette phase en fonction du domaine de température de service ;

- la première phase contient en outre du bore et le gaz réactif contient du monoxyde de silicium (SiO) et du monoxyde de bore (BO) ;

- on fait réagir sur le matériau composite d'abord un premier gaz réactif contenant du monoxyde de silicium (SiO) produit à partir du cément donneur contenant un mélange de silice ($SiO_2$) et de carbure de silicium (SiC) sous forme de poudre, puis un second gaz réactif contenant du monoxyde de silicium (SiO) et du monoxyde de bore (BO) produit à partir d'un second cément donneur contenant un mélange de silice ($SiO_2$) et de carbure de bore ($B_4C$) sous forme de poudre ;

- le chrome présent sur la surface à protéger est en tout ou partie un composant du matériau composite à base de silicium et de niobium ;

- le chrome présent sur la surface à protéger est obtenu en tout ou partie par un pré-dépôt sur la surface à protéger pour former une couche d'épaisseur désirée ;

- l'épaisseur de la couche de chrome est comprise entre 5 et 20 $\mu m$, l'épaisseur préférée étant de 15 $\mu m$ ;

- le pré-dépôt de chrome est obtenu par une technique de dépôt choisie parmi le groupe suivant : dépôt électrolytique, dépôt par pulvérisation cathodique ;

- on forme au préalable sur la surface à protéger un dépôt d'étain, de préférence suivi d'un traitement thermique sous vide ;

- on forme au préalable sur la surface à protéger un dépôt d'un métal précieux choisi parmi le platine, le palladium et l'or, de préférence suivi d'un recuit d'interdiffusion ;

- on forme au préalable sur la surface à protéger un dépôt de nitrure de titane ; et

- le matériau composite à base de silicium et de niobium présente la composition globale Nb 47 %, Si 16 %, Ti 25 %, Al 2%, Cr 2% et Hf 8 % (% atomiques).

Sous un autre aspect l'invention concerne le revêtement en lui-même obtenu par la mise en oeuvre du procédé ci-dessus et une pièce en matériau composite à base de silicium et de niobium dont une surface est munie d'un revêtement protecteur tel qu'obtenu par la mise en oeuvre du procédé ci-dessus.

Dans la description détaillée qui suit, faite seulement à titre d'exemple, on se réfère aux dessins annexés, sur lesquels :

- la figure 1 est un schéma illustrant la formation d'un revêtement protecteur selon l'invention en fonction du temps ;

- la figure 2 est une vue en surface, à échelle agrandie, d'un matériau composite de type Nb-Si protégé par un dépôt de chrome suivi par un traitement par un gaz SiO ;

- la figure 3 est une vue en coupe micrographique, à échelle agrandie, correspondante du matériau composite de la figure 2 ; et

- la figure 4 représente une vue en surface, à échelle agrandie, d'un matériau composite de type Nb-Si protégé par un dépôt de chrome suivi par un traitement au gaz SiO et un traitement au gaz SiO/BO.

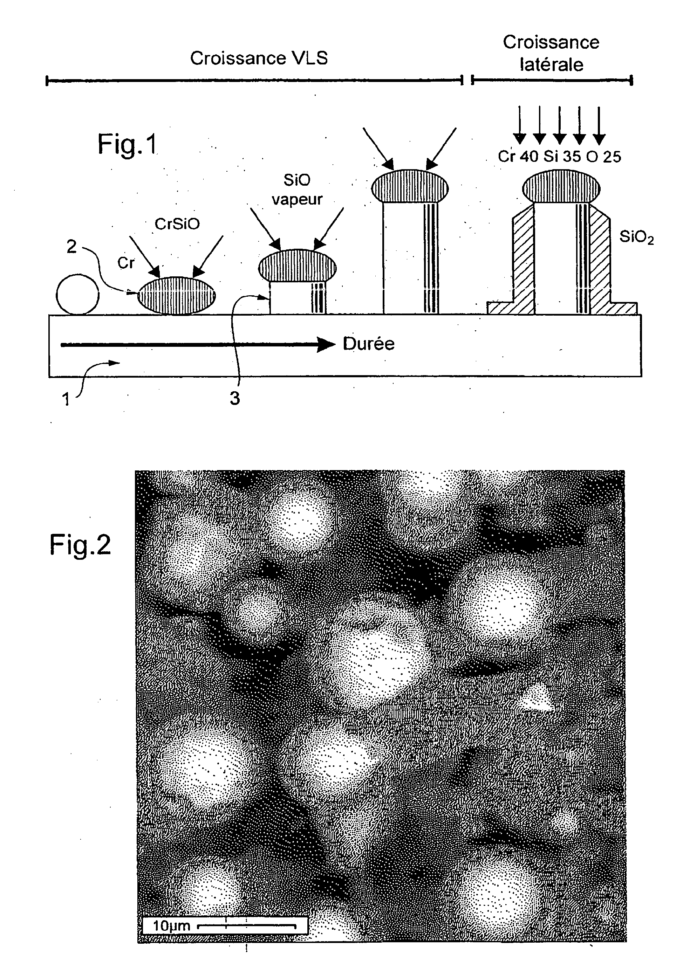

On se réfère d'abord au schéma de la figure 1. Comme mentionné précédemment, la technique privilégiée actuellement pour réaliser un dépôt protecteur conforme à l'invention est dérivée de la technique dite "VLS". On rappellera que cette technique consiste à placer un matériau dans une enceinte contenant un gaz donné. Il y a alors formation de gouttes liquides, soit à partir d'une réaction entre le gaz et "des éléments et impuretés" du matériau, soit à partir d'une réaction entre le gaz et un pré-dépôt généralement nanométrique.

Par effet catalytique, le gaz s'adsorbe dans la goutte et, quand il y a sursaturation en gaz dans la goutte, il se produit une nucléation et une croissance d'un cristal équiaxe.

Cette technique est utilisée actuellement dans des domaines techniques différents pour former des nanofils, des whiskers, des nano-structures de semi-conducteurs, etc., pour l'électronique ou des catalyseurs.

Dans le cas de la figure 1, on réalise un pré-dépôt de chrome sur une surface d'un matériau composite 1 de type Nb-Si avec une épaisseur de 15-20 $\mu$m et on place le tout dans une enceinte où du gaz SiO est produit in situ.

Il y a alors formation de "gouttes" ou boules 2 de CrSiO dans lesquelles le SiO s'adsorbe. Quand la composition $Cr_{40}Si_{35}O_{25}$ est atteinte, il y a nucléation de $SiO_2$ qui croît sous forme de tiges 3. A la température de l'essai (1450°C), la silice est plastique et il a y donc coalescence des phases et effondrement des boules de CrSiO qui coalescent. On ne retrouve la structure tige/boule typique d'une croissance VLS qu'en surface. Une partie du chrome a également diffusé dans le matériau composite à base de Nb-Si sous jacent et a donc assuré l'ancrage du revêtement (zone de diffusion).

La figure 1 montre de gauche à droite la formation de la goutte ou boule 2 de CrSiO par réaction du gaz SiO sur la surface d'un échantillon en présence de chrome, puis la formation des tiges 3 pendant la phase de croissance VLS, en fonction de la durée. Cette phase est suivie d'une phase de croissance latérale de $SiO_2$ comme on le voit sur la partie droite de la figure 1.

Dans le cas particulier de la figure 1, le chrome est apporté par un pré-dépôt. Mais il pourrait aussi, en variante, être apporté directement à partir de l'alliage, dont il forme alors un des composants. Il est possible aussi de réaliser l'apport de chrome à la fois à partir d'un composant de l'alliage et à partir d'un pré-dépôt sur la surface à protéger.

La figure 2 montre une vue en surface, à échelle agrandie (facteur d'agrandissement x2000 avec échelle 10 $\mu$m représentée), où l'on voit la structure tige/boule typique d'une croissance VLS. Toutefois, cette structure ne se retrouve qu'en surface.

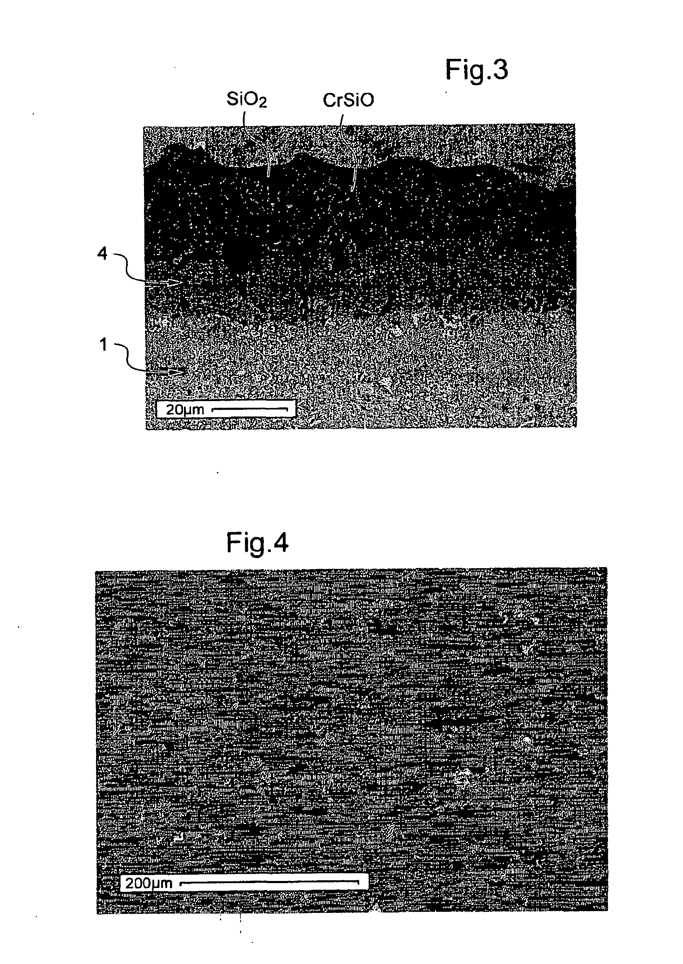

En effet, la coupe de la figure 3 (facteur d'agrandissement x1000 avec échelle 20 $\mu$m représentée) montre que l'on retrouve le matériau composite 1 surmonté par une zone d'ancrage 4 et ensuite surmonté par le revêtement avec les phases $SiO_2$ et CrSiO qui ont coalescé entre-elles.

Le gaz SiO est fabriqué in situ dans un four à partir d'un mélange $SiO_2$/SiC bien connu pour faire ce gaz. Il ne peut pas être obtenu en dessous de 1450°C. Il est employé dans la protection des composites carbone-carbone pour transformer le carbone en carbure de silicium selon la formule 2C + SiO = SiC + CO.

Ce gaz n'a jamais été fabriqué pour l'inclure dans un revêtement par une croissance de type VLS.

Il est possible aussi d'incorporer du bore. Pour cela, le mélange de poudre a été modifié par un nouveau mélange $SiO_2$/$B_4$C jamais utilisé jusqu'à présent.

Quand on dépose sur un matériau composite de type Nb-Si un dépôt de chrome et qu'on le met dans une enceinte où du gaz SiO est fabriqué à partir de SiO/SiC puis dans une enceinte où du gaz SiO/BO est créé à partir d'une

poudre $SiO_2/B_4C$, on incorpore du bore, ce qui permet d'obtenir un verre borosilicaté en surface qui est plus plastique que la silice. Un exemple est donné par la micrographie de la figure 4 (facteur d'agrandissement x1000 avec échelle 200 $\mu$m représentée). Cette dernière montre un matériau composite de type Nb-Si protégé d'abord par un pré-dépôt de chrome suivi par un traitement au gaz SiO et un traitement au gaz SiO/BO. L'aspect du revêtement est plus glacé en surface par comparaison à la figure 2.

L'invention sera en outre décrite en référence aux exemples non limitatifs suivants :

Exemple 1

On construit un revêtement protecteur sur un alliage de niobium et de silicium appelé MASC (Metal And Silicide Composite) de composition globale Nb 47 %, Si 16 %, Ti 25 %, Al 2%, Cr 2% et Hf 8 % (% atomiques). Cet alliage a été développé par General Electric (B.P. Bewlay, M.R. Jackson, and H.A. Lipsitt « The Balance of Mechanical and Environmental Properties of a Multielement Niobium-Niobium Silicide-Based In Situ Composite », Metall. Mater. Trans. 27A (1996) 3801-3808 ; brevet US 5 833 773). Il est composé de plusieurs phases réfractaires, une métallique (solution solide riche à base de niobium notée $M_{ss}$) et de plusieurs phases siliciures de niobium (de type $Nb_3Si$ et $Nb_5Si_3$)-L'échantillon est placé dans ou au dessus d'un cément donneur de silicium de composition :

$SiO_2$      75 %
SiC      25 % (pourcentages massiques)

Ces pourcentages correspondent à la composition stoechiométrique.

Porté à la température de 1450°C sous un débit d'argon, ce cément permet le transport de silicium à la surface du substrat. A la suite de cette opération on obtient un revêtement à base de $SiO_2$ + CrSiO dont les propriétés en oxydation à haute température sont exceptionnelles.

A 1200°C sous air en oxydation cyclique la durée de vie de l'alliage MASC ainsi protégé est 16 fois plus grande que celle du même alliage non protégé.

Exemple 2

On construit un revêtement protecteur sur un alliage de niobium et de silicium appelé MASC (Metal And Silicide Composite) tel que décrit dans l'exemple 1.

Pour ce faire on commence par revêtir le substrat par un dépôt de chrome électrolytique réalisé dans les conditions suivantes :

Trioxyde de chrome dit acide chromique ($CrO_3$) : 250 g.L$^{-1}$
Acide sulfurique ($H_2SO_4$) : 2,5 g.L$^{-1}$
Densité de courant : 50 A/dm$^2$
T : 60-65°C

L'électrolyse dure entre 0,5 et 3 heures, selon l'épaisseur désirée. On dépose une couche comprise entre 5 et 20 $\mu$m, l'épaisseur préférée étant de 15 $\mu$m.

Optionnellement, le substrat revêtu de chrome peut être ensuite soumis à un traitement thermique de diffusion, par exemple de 2 heures à 900°C sous un vide meilleur que $10^{-3}$ Pa. À la suite de cette opération l'échantillon est placé dans ou au dessus d'un cément donneur de silicium de composition

$SiO_2$      75 %
SiC      25 % (pourcentages massiques)

Porté à la température de 1450°C sous débit d'argon, ce cément permet le transport de silicium à la surface du substrat. A la suite de cette opération on obtient un revêtement à base de $SiO_2$ + CrSiO dont les propriétés en oxydation à haute température sont exceptionnelles. L'échantillon présente un gain de masse de 1 mg/cm$^2$ après 45 cycles d'oxydation d'une heure à 1200°C, alors qu'un échantillon non protégé est détruit en moins d'une heure.

Exemple 3

On construit un revêtement protecteur sur un alliage de niobium et de silicium appelé MASC (Metal And Silicide Composite) tel que décrit dans l'exemple 1.

Pour ce faire on commence par revêtir le substrat par un dépôt de chrome par pulvérisation cathodique triode. La couche déposée a une épaisseur comprise entre 5 et 20 $\mu$m, l'épaisseur préférée étant de 15 $\mu$m. L'échantillon est placé dans ou au dessus d'un cément donneur de silicium de composition :

| | |
|---|---|
| $SiO_2$ | 75 % |
| SiC | 25 % (pourcentages massiques) |

Porté à la température de 1450°C sous débit d'argon, ce cément permet le transport de silicium à la surface du substrat. A la suite de cette opération on obtient un revêtement à base de $SiO_2$ + CrSiO dont les propriétés en oxydation à haute température sont exceptionnelles.

A titre d'exemple un échantillon protégé par ce revêtement a été oxydé pendant 45 cycles d'une heure à la température de 1200°C. A l'issue du test il présentait une perte de masse de 1,63 mg/cm$^2$ alors que le même échantillon non protégé est totalement détruit en moins d'une heure.

Exemple 4

On procède comme dans l'exemple précédent à la différence près que le cément est donneur à la fois de silicium et de bore. Le cément a la composition suivante :

| | |
|---|---|
| $SiO_2$ | 50 % |
| $B_4C$ | 50 % (pourcentages massiques) |

Ici aussi les résultats obtenus sont exceptionnels : le substrat MASC est revêtu par un dépôt d'oxyde de silice, d'oxyde de chrome, de borure de chrome et d'oxysiliciure de chrome dont les propriétés en oxydation à haute température sont exceptionnelles.

Par exemple l'échantillon oxydé pendant 20 cycles d'une heure à 1000°C présentait une perte de masse de 0,14 mg/cm$^2$ alors que le même échantillon non protégé est totalement détruit à cette même température en une heure.

Exemple 5

On procède comme dans l'exemple précédent à la différence près que le cément donneur a la fois de silicium et de bore est plus riche en bore que le précédent. Le cément a la composition suivante :

| | |
|---|---|
| $SiO_2$ | 16 % |
| $B_4C$ | 84 % (pourcentages massiques) |

Ici aussi le revêtement obtenu présente une résistance exceptionnelle à l'oxydation à haute température.

Exemple 6

On procède comme dans l'exemple 3 puis on fait un second traitement où l'échantillon est placé dans ou au dessus d'un cément donneur à la fois de silicium et de bore. Le second cément a la composition suivante :

| | |
|---|---|
| $SiO_2$ | 50% |
| $B_4C$ | 50 % (pourcentages massiques) |

L'échantillon a été soumis à un test d'oxydation de 50 cycles d'une heure à 1000°C. A l'issue de ce test il présentait une prise de masse de 0,74 mg/cm$^2$ alors que le même échantillon, non protégé, est totalement détruit à cette température en une heure.

Exemple 7

On procède comme dans l'exemple 3, puis on fait un second traitement où l'échantillon est placé dans ou au dessus d'un cément donneur à la fois de silicium et de bore mais plus riche en bore que celui de l'exemple 6. Le second cément a la composition suivante :

$$SiO_2 \quad 16\ \%$$
$$B_4C \quad 84\ \% \text{ (pourcentages massiques)}$$

L'échantillon a été soumis à un test d'oxydation de 300 cycles d'une heure à 1000°C. A l'issue de ce test il présentait une perte de masse de 1,09 mg/cm$^2$, alors que le même échantillon, non protégé, est totalement détruit à cette température en une heure.

Cependant, il faut noter qu'en cas de destruction totale du revêtement, par fissuration accidentelle par exemple, et compte tenu de la médiocre résistance à l'oxydation des matériaux de type Nb-Si, il y a oxydation du substrat sous jacent ce qui entraîne l'écaillage du revêtement et la destruction du matériau.

Pour y remédier on se propose, avant de réaliser le revêtement tel que décrit plus haut, de modifier localement la surface de l'alliage qui sera en contact avec le revêtement soit par un élément reconnu comme améliorant la résistance à l'oxydation des substrats massifs comme l'étain ou un métal noble (platine, or) [Geng et al Intermetallics 15 (2007) 270-281] soit en y déposant une barrière de diffusion à l'oxygène comme par exemple le nitrure de titane dont les propriétés comme barrière de diffusion sont bien connues par l'homme de l'art.

Exemple 8

On construit un revêtement protecteur sur un alliage de niobium et de silicium appelé MASC. Pour ce faire on commence par revêtir le substrat par un dépôt d'étain de 4 à 7 $\mu$m suivi d'un traitement thermique sous vide à 700°C pendant une durée de 12 à 32h. Puis on procède comme dans l'exemple 1.

Ici aussi les résultats obtenus sont exceptionnels : le substrat MASC est revêtu par un dépôt dont les propriétés en oxydation à haute température sont exceptionnelles

Exemple 9

On construit un revêtement protecteur sur un alliage de niobium et de silicium appelé MASC. Pour ce faire on commence par revêtir le substrat par un dépôt d'étain de 4 à 7 $\mu$m suivi d'un traitement thermique sous vide à 700°C pendant une durée de 12 à 32 h. Puis on procède comme dans l'exemple 2.

Ici aussi les résultats obtenus sont exceptionnels : le substrat MASC est revêtu par un dépôt dont les propriétés en oxydation à haute température sont exceptionnelles

Exemple 10

On construit un revêtement protecteur sur un alliage de niobium et de silicium appelé MASC. Pour ce faire on commence par revêtir le substrat par un dépôt d'étain de 4 à 7 $\mu$m suivi d'un traitement thermique sous vide à 700°C pendant une durée de 12 à 32 h. Puis on procède comme dans les exemples 3 à 7 selon les propriétés recherchées pour le revêtement.

Ici aussi les résultats obtenus sont exceptionnels : le substrat MASC est revêtu par un dépôt dont les propriétés en oxydation à haute température sont exceptionnelles

Exemple 11

On répète les exemples 8 à 10 en remplaçant le dépôt d'étain par un dépôt de platine obtenu par une des techniques bien connues de l'homme de l'art, suivi éventuellement d'un recuit d'interdiffusion.

Dans tous les cas on obtient un revêtement avec de bonnes propriétés en oxydation à haute et moyenne température.

Exemple 12

On répète les exemples 8 à 10 en remplaçant le dépôt d'étain par un dépôt de palladium obtenu par une des techniques bien connues de l'homme de l'art, suivi éventuellement d'un recuit d'interdiffusion.

Dans tous les cas on obtient un revêtement avec de bonnes propriétés en oxydation à haute et moyenne température.

Exemple 13

On répète les exemples 8 à 10 en remplaçant le dépôt d'étain par un dépôt d'or obtenu par une des techniques bien connues de l'homme de l'art, suivi éventuellement d'un recuit d'interdiffusion.

Dans tous les cas on obtient un revêtement avec de bonnes propriétés en oxydation à haute et moyenne température.

Exemple 14

On répète les exemples 8 à 10 en remplaçant le dépôt d'étain par un dépôt de nitrure de titane obtenu par une des techniques bien connues de l'homme de l'art.

Dans tous les cas on obtient un revêtement avec de bonnes propriétés en oxydation à haute et moyenne température.

Exemple 15

On répète les exemples précédents 1, 2, 3, 6 à 14 en remplaçant le cément SiO2/SiC (silice/carbure de silicium) par une poudre de SiO commerciale qui par chauffage s'évapore en gaz SiO comme mentionné dans le brevet US 6,313,015.

Exemple 16

On répète les exemples précédents 1, 2, 3, 6 à 14 à la différence près que la source de monoxyde de silicium gaz (SiO) est obtenue par activation de mélange de poudres de silicium (Si) et de silice (SiO2), activation réalisée par traitement thermique, chauffage laser, plasma cathodique triode ou magnétron comme mentionné dans le brevet US 6,313,015. Ici aussi le revêtement obtenu présente une résistance exceptionnelle à l'oxydation à haute température. Un même résultat peut être obtenu par activation de cibles obtenues par compactage des dites poudres ou à partir de cibles taillées dans du matériau massif de même composition que les dites poudres.

L'invention trouve une application préférentielle dans le domaine des moteurs aéronautiques.

**Revendications**

1.  Procédé pour former un revêtement protecteur contre l'oxydation à haute température sur une surface d'un matériau composite réfractaire à base de silicium et de niobium, **caractérisé en ce que** l'on fait réagir sur du chrome présent sur la surface à protéger un gaz réactif contenant du silicium et de l'oxygène pour élaborer un revêtement composite à deux phases, dont la première phase est une phase oxyde à base de silice ($SiO_2$) présentant des caractéristiques viscoplastiques ajustables et dont la seconde phase est à base de silicium, de chrome et d'oxygène (CrSiO), et **en ce que** l'on fait coalescer lesdites première phase et seconde phase à haute température, ce qui permet de former un revêtement protecteur dans lequel la seconde phase sert de réservoir pour reformer, en service, la première phase par réaction avec un gaz oxydant.

2.  Procédé selon la revendication 1, dans lequel le gaz réactif contient du monoxyde de silicium (SiO) et est produit in situ à partir d'un cément donneur contenant de la silice ($SiO_2$) soumis à une température supérieure ou égale à 1450°C.

3.  Procédé selon la revendication 2, dans lequel le cément donneur contient un mélange de silice ($SiO_2$) et de carbure de silicium (SiC) sous forme de poudre.

4.  Procédé selon l'une des revendications 1 à 3, dans lequel la première phase à base de silice ($SiO_2$) contient en outre des éléments fondants de type bore et/ou germanium, ce qui permet d'ajuster les caractéristiques viscoplastiques de cette phase en fonction du domaine de température de service.

5.  Procédé selon la revendication 4, dans lequel la première phase contient en outre du bore et dans lequel le gaz réactif contient du monoxyde de silicium (SiO) et du monoxyde de bore (BO).

6.  Procédé selon la revendication 5, dans lequel on fait réagir sur le matériau composite d'abord un premier gaz réactif contenant du monoxyde de silicium (SiO) produit à partir du cément donneur contenant de la silice ($SiO_2$) et du

carbure de silicium (SiC) sous forme de poudre, puis un second gaz réactif contenant du monoxyde de silicium (SiO) et du monoxyde de bore (BO) produit d'un second cément donneur contenant de la silice ($SiO_2$) et du carbure de bore ($B_4C$) sous forme de poudre.

**7.** Procédé selon l'une des revendications 1 à 6, dans lequel tout ou partie du chrome présent sur la surface à protéger est issu du matériau composite à base de silicium et de niobium.

**8.** Procédé selon l'une des revendications 1 à 6, dans lequel tout ou partie du chrome présent sur la surface à protéger est obtenu par un pré-dépôt sur la surface à protéger pour former une couche d'épaisseur désirée.

**9.** Procédé selon la revendication 8, dans lequel le pré-dépôt est obtenu par une technique de dépôt électrolytique ou de dépôt par pulvérisation cathodique et l'épaisseur désirée de la couche étant comprise entre 5 et 20 $\mu$m, l'épaisseur préférée étant de 15 $\mu$m.

**10.** Procédé selon l'une des revendications 1 à 8, dans lequel on forme au préalable sur la surface à protéger un dépôt d'étain, de préférence suivi d'un traitement thermique sous vide.

**11.** Procédé selon l'une des revendications 1 à 8, dans lequel on forme au préalable sur la surface à protéger un dépôt d'un métal précieux choisi parmi le platine, le palladium et l'or, de préférence suivi d'un recuit d'interdiffusion.

**12.** Procédé selon l'une des revendications 1 à 8, dans lequel on forme au préalable sur la surface à protéger un dépôt de nitrure de titane.

**13.** Revêtement protecteur obtenu par la mise en oeuvre du procédé selon l'une des revendications 1 à 12.

**14.** Pièce en matériau composite à base de silicium et de niobium dont une surface est munie d'un revêtement protecteur tel qu'obtenu par la mise en oeuvre du procédé selon l'une des revendications 1 à 12.


**Patentansprüche**

**1.** Verfahren zum Ausbilden eines Schutzüberzugs gegen Oxidation bei hoher Temperatur auf einer Oberfläche eines feuerfesten Verbundwerkstoffs auf Grundlage von Silicium und Niob, **dadurch gekennzeichnet, dass** auf Chrom, das auf der zu schützenden Oberfläche vorhanden ist, ein reaktives Gas zur Reaktion gebracht wird, das Silicium und Sauerstoff enthält, um einen Zweiphasen-Verbundüberzug zu bilden, dessen erste Phase eine Oxidphase auf Grundlage von Siliciumdioxid ($SiO_2$) ist, die einstellbare zähelastische Eigenschaften aufweist, und dessen zweite Phase auf Grundlage von Silicium, Chrom und Sauerstoff (CrSiO) ist, und dass diese erste und zweite Phase bei hoher Temperatur zum Koaleszieren gebracht werden, wodurch sich ein Schutzüberzug ausbilden lässt, wobei die zweite Phase als Reservoir dient, um im Betrieb die erste Phase durch Reaktion mit einem oxidierenden Gas zu reformieren.

**2.** Verfahren nach Anspruch 1, wobei das reaktive Gas Siliciummonoxid (SiO) enthält und *in situ* aus einem Geberzement erzeugt wird, der Siliciumdioxid ($SiO_2$) enthält, das einer Temperatur von über oder gleich 1450°C ausgesetzt wird.

**3.** Verfahren nach Anspruch 2, wobei der Geberzement ein Gemisch aus Siliciumdioxid ($SiO_2$) und Siliciumcarbid (SiC) in Pulverform enthält.

**4.** Verfahren nach einem der Ansprüche 1 bis 3, wobei die erste Phase auf Grundlage von Siliciumdioxid ($SiO_2$) darüber hinaus Schmelzelemente der Art Bor und/oder Germanium enthält, wodurch sich die zähelastischen Eigenschaften dieser Phase in Abhängigkeit vom Betriebstemperaturbereich einstellen lassen.

**5.** Verfahren nach Anspruch 4, wobei die erste Phase darüber hinaus Bor enthält, und wobei das reaktive Gas Siliciummonoxid (SiO) und Bormonoxid (BO) enthält.

**6.** Verfahren nach Anspruch 5, wobei auf dem Verbundwerkstoff zunächst ein erstes reaktives Gas, das Siliciummonoxid (SiO) enthält, das aus dem Geberzement erzeugt wird, der Siliciumdioxid ($SiO_2$) und Siliciumcarbid (SiC) in Pulverform enthält, dann ein zweites reaktives Gas zur Reaktion gebracht wird, das Siliciummonoxid (SiO) und Bormonoxid (BO) enthält, das aus einem zweiten Geberzement erzeugt wird, der Siliciumdioxid (SiO$_2$) und Borcarbid (B$_4$C) in Pulverform enthält.

7. Verfahren nach einem der Ansprüche 1 bis 6, wobei das Chrom, das auf der zu schützenden Oberfläche vorhanden ist, ganz oder teilweise aus dem Verbundwerkstoff auf Grundlage von Silicium und Niob hervorgeht.

8. Verfahren nach einem der Ansprüche 1 bis 6, wobei das Chrom, das auf der zu schützenden Oberfläche vorhanden ist, durch eine Vorabscheidung auf der zu schützenden Oberfläche, um eine Schicht mit einer gewünschten Dicke auszubilden, erhalten wird.

9. Verfahren nach Anspruch 8, wobei die Vorabscheidung durch ein technisches galvanisches Abscheidungsverfahren oder Kathodenzerstäubungsabscheidungsverfahren erzielt wird, und die gewünschte Dicke der Schicht zwischen 5 und 20 µm beträgt, wobei die bevorzugte Dicke 15 µm beträgt.

10. Verfahren nach einem der Ansprüche 1 bis 8, wobei zuvor auf der zu schützenden Oberfläche eine Zinnabscheidung hergestellt wird, auf die vorzugsweise eine Wärmebehandlung in Vakuum folgt.

11. Verfahren nach einem der Ansprüche 1 bis 8, wobei zuvor auf der zu schützenden Oberfläche eine Abscheidung eines Edelmetalls hergestellt wird, das aus Platin, Palladium und Gold ausgewählt ist, auf die vorzugsweise ein Interdiffusionstempern folgt.

12. Verfahren nach einem der Ansprüche 1 bis 8, wobei zuvor auf der zu schätzenden Oberfläche eine Titannitridabscheidung hergestellt wird.

13. Schutzüberzug, der durch Umsetzung des Verfahrens nach einem der Ansprüche 1 bis 12 erhalten wird.

14. Teil aus Verbundwerkstoff auf Grundlage von Silicium und Niob, wovon eine Oberfläche mit einem wie nach der Umsetzung des Verfahrens nach einem der Ansprüche 1 bis 12 erhaltenen Schutzüberzug versehen ist.

**Claims**

1. Method for forming a protective coating against high-temperature oxidation on a surface of a refractory composite material based on silicon and niobium, **characterised in that** chromium present on the surface to be protected is reacted with a reactive gas which contains silicon and oxygen in order to produce a composite coating having two phases, the first phase of which is an oxide phase based on silica (SiO$_2$) which has adjustable viscoplastic properties and the second phase of which is based on silicon, chromium and oxygen (CrSiO), and **in that** the first phase and second phase are coalesced at high temperature, which allows a protective coating to be formed in which the second phase acts as a reservoir to reform, during operation, the first phase by means of reaction with an oxidising gas.

2. Method according to claim 1, wherein the reactive gas contains silicon monoxide (SiO) and is produced in situ from a donor cement which contains silica (SiO$_2$) subjected to a temperature greater than or equal to 1450°C.

3. Method according to claim 2, wherein the donor cement contains a mixture of silica (SiO$_2$) and silicon carbide (SiC) in the form of powder.

4. Method according to one of claims 1 to 3, wherein the first phase based on silica (SiO$_2$) further contains melting elements of the boron and/or germanium type which allows the viscoplastic properties of this phase to be adjusted in accordance with the operating temperature range.

5. Method according to claim 4, wherein the first phase further contains boron and wherein the reactive gas contains silicon monoxide (SiO) and boron monoxide (BO).

6. Method according to claim 5, wherein there is first reacted on the composite material a first reactive gas containing silicon monoxide (SiO) produced from the donor cement which contains silica (SiO$_2$) and silicon carbide (SiC) in the form of powder, then a second reactive gas which contains silicon monoxide (SiO) and boron monoxide (BO) produced from a second donor cement which contains silica (SiO$_2$) and boron carbide (B$_4$C) in the form of powder.

7. Method according to one of claims 1 to 6, wherein all or part of the chromium present on the surface to be protected originates from the composite material based on silicon and niobium.

8. Method according to one of claims 1 to 6, wherein all or part of the chromium present on the surface to be protected is obtained by means of a predeposit on the surface to be protected in order to form a layer of the desired thickness.

9. Method according to claim 8, wherein the predeposit is obtained by means of an electrolytic depositing technique or depositing by means of cathode spraying and the desired thickness of the layer being between 5 and 20 $\mu$m, the preferred thickness being 15 $\mu$m.

10. Method according to one of claims 1 to 8, wherein there is formed beforehand on the surface to be protected a deposit of tin, preferably followed by a thermal processing operation under vacuum.

11. Method according to one of claims 1 to 8, wherein there is formed beforehand on the surface to be protected a deposit of a precious metal which is selected from platinum, palladium and gold, preferably followed by an interdiffusion annealing operation.

12. Method according to one of claims 1 to 8, wherein there is formed beforehand on the surface to be protected a deposit of titanium nitride.

13. Protective coating obtained by implementing the method according to one of claims 1 to 12.

14. Component of composite material based on silicon and niobium, one surface of which is provided with a protective coating, such as that obtained by implementing the method according to one of claims 1 to 12.

Croissance VLS | Croissance latérale

Fig.1

Cr 40 Si 35 O 25

SiO
vapeur

CrSiO

2

Cr

SiO₂

Durée

1

3

Fig.2

10μm

Fig.3

SiO$_2$    CrSiO

Fig.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4904546 A, M. R. Jackson
- US 4980244 A
- US 5019334 A, M. R. Jackson
- US 5932033 A, M. R. Jackson
- US 6419765 B
- US 6521356 B, Zhao
- US 5833773 A
- US 6313015 B

**Littérature non-brevet citée dans la description**

- **GUO, X.P. ; ZHAO, L.X. ; GUAN, P. ; KUSABIRAKI, K.** *Materials Science Forum,* 2007, vol. 561-565, 371-374
- **XIAOXIA LI ; CHINGEN ZHOU.** *Materials Science Forum,* 2007, vol. 546-549, 1721-1724
- **CHEN CHEN et al.** *Intermetallics,* 2007, vol. 15, 805-809
- *Surface and Coating Technology,* 2009, vol. 203, 1161-1166
- *Surface and Coating Technology,* 2009, vol. 204, 313-318
- **B.P. BEWLAY ; M.R. JACKSON ; H.A. LIPSITT.** The Balance of Mechanical and Environmental Properties of a Multielement Niobium-Niobium Silicide-Based In Situ Composite. *Metall. Mater. Trans.,* 1996, vol. 27A, 3801-3808
- **GENG et al.** *Intermetallics,* 2007, vol. 15, 270-281